# EUROPÄISCHE PATENTSCHRIFT

(11) **EP 2 901 460 B1**
(45) Veröffentlichungstag und Bekanntmachung des Hinweises auf die Patenterteilung: **13.04.2016**
(21) Anmeldenummer: 14783583.9
(22) Anmeldetag: 02.10.2014
(51) Int. Cl.: H01F 6/06, G01R 33/3815

(54) **MAGNETSPULENANORDNUNG UMFASSEND EINEN HTSL-BANDLEITER UND EINEN LTS-DRAHT, DIE EINEN JOINT AUSBILDEN**
MAGNETIC COIL ARRANGEMENT COMPRISING A HTSC BAND CONDUCTOR AND A LTSC WIRE, FROMING A JOINT
ENSEMBLE BOBINE MAGNETIQUE COMPRENANT UN SUPRACONDUCTEUR À HAUTE TEMPÉRATURE SOUS FORME DE BANDE ET UN SUPRACONDUCTEUR À BASSE TEMPÉRATURE SOUS FORME DE FIL, FORMANT UN JOINT

(30) Priorität: 04.10.2013 DE 102013220142
(43) Veröffentlichungstag der Anmeldung: 05.08.2015
(73) Patentinhaber: Bruker BioSpin GmbH, 76287 Rheinstetten (DE)
(72) Erfinder: ROTH, Gerhard, 76287 Rheinstetten (DE); KASTEN, Arne, 76139 Karlsruhe (DE)
(74) Vertreter: Kohler Schmid Möbus Patentanwälte
(86) Internationale Anmeldenummer: PCT/EP2014/071208
(87) Internationale Veröffentlichungsnummer: WO 2015/049358

(56) Entgegenhaltungen:
- WO-A1-2012/004581
- CN-A- 101 694 908
- CN-U- 202 887 898
- DE-A1- 3 905 424
- DE-A1- 10 117 370
- DE-A1-102004 007 340
- DE-B3-102006 012 511
- US-A1- 2009 264 297

## Beschreibung

Die Erfindung betrifft eine Magnetspulenanordnung, umfassend
- mindestens eine Spulensektion, die mit einem Hochtemperatursupraleiter(=HTSL)-Bandleiter gewickelt ist,
- und einen Tieftemperatursupraleiter(=LTS)-Draht,
wobei der HTSL-Bandleiter und der LTS-Draht elektrisch in Serie geschaltet sind.

Eine solche Magnetspulenanordnung ist beispielsweise aus der DE 10 2004 007 340 A1 bekannt geworden.

Supraleiter können elektrische Ströme praktisch ohne ohmsche Verluste tragen. Sie werden insbesondere dort, wo hohe elektrische Stromstärken benötigt werden, eingesetzt, so auch in Magnetspulen.

In Magnetspulen werden üblicherweise zwei Arten von Supraleitern verbaut. Metallische Tieftemperatursupraleiter (LTS, low temperature superconductor), wie NbTi oder Nb3Sn, liegen meist als Drähte vor, die Filamente aus dem LTS-Material enthalten. Keramische Hochtemperatursupraleiter (HTS, high temperature supcerconductors, auch HTSL), etwa vom ReBCO- Typ, liegen in der Regel als eine Beschichtung auf einem bandförmigen Substrat, etwa einem Stahlband, vor. HTSL-Supraleiter vom BSCCO-Typ sind ebenfalls meist bandförmig, besitzen aber wie LTS-Leiter Filamente, die meistens in eine Silbermatrix eingebettet sind.

In der DE 10 2004 007 340 A1 wird ein Magnetfeldsystem mit radial geschachtelten Teilspulen vorgeschlagen, wobei eine LTS-Teilspule und eine HTS-Teilspule elektrisch in Serie geschaltet sind und über einen LTS-HTS-Joint miteinander verbunden sind. Einzelheiten zum Jointaufbau werden nicht genannt.

An einem Joint erfolgt ein Stromübergang zwischen zwei Supraleiter-Teilstücken. Dabei ist es technisch schwierig, einen echt supraleitenden Stromübergang zwischen den Supraleiter-Teilstücken einzurichten; oftmals muss ein zwar extrem kleiner, aber doch merklicher ohmscher Widerstand an einem Joint in Kauf genommen werden. Letzteres gilt insbesondere für Joints zwischen LTS- und HTS-Materialien. Solche ohmschen Widerstände können insbesondere zu einer störenden Drift im kurzgeschlossenen Betrieb einer Magnetspulenanordnung ("persistent mode") führen.

DE 10 2006 012 511 B3 offenbart ebenfalls eine Magnetspulenanordnung gemäss Oberbegriff von Anspruch 1.

CN101694908 und DE 101 17 370 A1 offenbaren Ausführungen von HTS/LTS Joints. US 2009/0264297, CN 202887898U, DE 39 05 424 A1 und WO 2012/004581 A1 offenbaren Ausführungen von supraleitenden Joints.

### Aufgabe der Erfindung

Der Erfindung liegt die Aufgabe zugrunde, bei einer Magnetspulenanordnung der eingangs genannten Art auf einfache Weise einen akzeptabel kleinen verbleibenden ohmschen Widerstand zu erreichen. Insbesondere soll die Magnetspulenanordnung eine hinreichend geringe Drift im Kurzschlussbetrieb ermöglichen.

### Kurze Beschreibung der Erfindung

Diese Aufgabe wird gelöst durch eine Magnetspulenanordnung gemäss Anspruch 1.

Gemäß der Erfindung werden der HTSL-Bandleiter und der LTS-Draht über eine größere Länge, d.h. über einen im Vergleich zur Breite der beteiligten Leiter vielfach (meist wenigstens 10fach oder auch wenigstens 100fach) längeren Verbindungsabschnitt, in welchem sie parallel zueinander geführt sind, elektrisch leitend miteinander verbunden. Im Verbindungsabschnitt (Verbindungsbereich) überlappen der HTSL-Bandleiter und der LTS-Draht und stehen in einem ohmschen (icht supraleitendem) Kontakt, typischerweise durch ein oder mehrere metallische Schichten (etwa Kupferschichten) und/oder ein Lot.

Aufgrund der großen Länge des Verbindungsabschnitts von wenigstens, 5m, bevorzugt 10 m oder mehr, oder auch 20 m oder mehr, bzw. der entsprechend großen Fläche, über die ein transversaler Stromübergang erfolgen kann, ist jedoch der ohmsche Querwiderstand sehr klein und kann für typische Magnetspulenanwendungen nahezu vernachlässigt werden, so dass eine quasi supraleitende Verbindung eingerichtet ist. Insbesondere verursacht der Joint nur eine sehr kleine Drift im Falle eines Kurzschlussbetriebs der erfindungsgemäßen Magnetspulenanordnung, die leicht mit üblichen Kompensationsmethoden ausgeglichen werden kann, falls erforderlich bzw. gewünscht.

### Bevorzugte Ausführungsformen der Erfindung

### Ausführungsformen mit aufgewickeltem Verbindungsabschnitt

Bei einer besonders bevorzugten Ausführungsform der erfindungsgemäßen Magnetspulenanordnung ist der Verbindungsabschnitt aufgewickelt. Dadurch kann der Verbindungsabschnitt platzsparend untergebracht werden, und ebenso ist es auf einfache Weise möglich, den Verbindungsabschnitt bzw. den darin enthaltenen HTSL-Bandleiter gezielt gegenüber dem von der Magnetspulenanordnung erzeugten Magnetfeld zu orientieren. Insbesondere kann eine Orientierung bzw. Positionierung eingerichtet werden, bei der das erzeugte lokale Magnetfeld überall im Verbindungsabschnitt im Wesentlichen parallel zur lokalen Bandebene des Bandleiters verläuft. Dabei kann insbesondere ein Träger für den Verbindungsabschnitt vorgesehen sein, in dem eine Führung für den HTSL-Bandleiter (und den LTS-Draht) ausgebildet (beispielsweise eingefräst) ist, mit der der HTSL-Bandleiter so geführt wird, dass dessen lokale Bandebene überall parallel zur Richtung des lokalen Magnetfelds der Magnetspulenanordnung liegt; der Verlauf des Magnetfelds der Magnetspulenanordnung kann vorab berechnet werden. Dadurch kann die Stromtragfähigkeit des HTSL-Bandleiters im Verbindungsabschnitt optimiert werden. Alternativ ist es auch möglich, den Verbindungsabschnitt beispielsweise zu einem Knäuel zu formen und in eine Schachtel einzuführen.

Vorteilhaft ist eine Weiterbildung dieser Ausführungsform, die vorsieht, dass der HTSL-Bandleiter im Bereich des Verbindungsabschnitts mit einer jeweiligen lokalen Bandebene im Wesentlichen parallel zu einer Wickelachse verläuft, und dass der Verbindungsabschnitt so positioniert ist, dass das von der Magnetspulenanordnung im Betrieb erzeugte Magnetfeld im Bereich des Verbindungsabschnitts im Wesentlichen parallel zur Wickelachse verläuft. Auf diese Weise kann sehr einfach eine für eine gute Stromtragfähigkeit günstige Orientierung des HTSL-Bandleiters zum statischen Magnetfeld eingerichtet werden. Die lokale Bandebene bestimmt sich durch die lokale Tangentialebene des Bandleiters. Gemäß dieser Weiterbildung ist die lokale Bandebene überall im Verbindungsabschnitt im Wesentlichen parallel zur Wickelachse. Der Bandleiter wird typischerweise Windung auf Windung um die Wickelachse herum gewickelt; ebenso kann der Bandleiter auch mit mehreren Windungen pro Lage (in einer oder mehreren Lagen) um die Wickelachse herum gewickelt werden. Am einfachsten erfolgt dabei das Aufwickeln auf einem zylindrischen Wickelkörper. Durch die Positionierung und Ausrichtung des Verbindungsabschnitts bzw. der Wickelachse im Magnetfeld gemäß dieser Weiterbildung wird automatisch erreicht, dass das Magnetfeld lokal im Wesentlichen parallel zur supraleitenden HTSL-Schicht im Bandleiter verläuft, wodurch größtmögliche kritische Ströme im HTSL-Bandleiter eingerichtet werden. Eine Ausrichtung wird im Rahmen der Erfindung als im Wesentlichen parallel angesehen, wenn die Abweichung von der Parallelität weniger als 20° beträgt, bevorzugt weniger als 10°, besonders bevorzugt weniger als 5°.

Bevorzugt ist bei dieser Weiterbildung vorgesehen, dass die Wickelachse gegenüber einer Spulenachse der Magnetspulenanordnung gekippt ist, insbesondere mit einem Kippwinkel zwischen 20° und 70°, bevorzugt zwischen 30° und 60°. Durch die Kippung der Wickelachse gegen die Spulenachse (Längsachse der Magnetspulenanordnung) kann eine Anpassung an den lokalen Magnetfeldlinienverlauf erfolgen, und Querkomponenten des Magnetfelds auf die HTSL-Bandleiter können minimiert werden. Der Verbindungsabschnitt kann in einem weiten Raumbereich platziert werden.

Vorteilhaft ist auch eine Weiterbildung, bei der der Verbindungsabschnitt nach Art einer Pancake-Spule aufgewickelt ist. In diesem Fall weist jede Lage nur eine Windung (von HTSL-Bandleiter und LTS-Draht) auf, was besonders einfach zu wickeln ist und Biegungen bei Lagenübergängen vermeidet. Der in dieser Weiterbildung im Wesentlichen scheibenförmige Verbindungsabschnitt kann, falls gewünscht, leicht gebogen ausgebildet sein, um eine Anpassung an den lokale Magnetfeldverlauf vorzunehmen und die Stromtragfähigkeit zu maximieren; die lokale Scheibenebene verläuft dann im Wesentlichen senkrecht zu den lokalen Magnetfeldlinien.

Bei einer alternativen Weiterbildung ist der Verbindungsabschnitt nach Art einer Solenoidspule aufgewickelt. In diesem Fall werden in einer Lage mehrere Windungen axial benachbart gewickelt; die Solenoidspule kann eine oder auch mehrere radial übereinanderliegende Lagen umfassen. Bei dieser Weiterbildung können auch größere Längen des Verbindungsabschnitts, insbesondere von 10 m oder mehr, räumlich kompakt untergebracht werden; eine radiale Ausdehnung des aufgewickelten Verbindungsabschnitts kann (im Vergleich zu einer Pancake-Spule) gering gehalten werden, was es vereinfacht, den Winkel zwischen dem lokalen Magnetfeld und der lokalen Bandebene gering zu halten.

Bevorzugt ist bei dieser Weiterbildung vorgesehen, dass eine Solenoidspulenachse, um die der Verbindungsabschnitt gewickelt ist, gekrümmt verläuft, insbesondere wobei der Verlauf der Solenoidspulenachse dem Feldlinienverlauf eines von der Magnetspulenanordnung im Betrieb erzeugten, lokalen Magnetfelds entspricht. Dadurch kann eine Querkomponente des Magnetfelds auf den HTSL-Bandleiter im Verbindungsabschnitt minimiert werden, und so die Stromtragfähigkeit optimiert werden. Diese Ausführungsform ist insbesondere nützlich, wenn der aufgewickelte Verbindungsabschnitt eine merkliche axiale Ausdehnung besitzt.

Vorteilhaft ist auch eine Weiterbildung, bei der der Verbindungsabschnitt auf einem Wickelkörper mit kreisrundem Außenquerschnitt aufgewickelt ist. Dadurch kann die Krümmung am HTSL-Bandleiter über die lange Seite gleichmäßig gering gehalten werden, was Beschädigungen insbesondere in der HTSL-Schicht im Bandleiter vermeidet.

Bei einer alternativen Weiterbildung ist der Verbindungsabschnitt auf einem Wickelkörper mit einem länglichen, an gegenüberliegenden Enden abgerundeten Außenquerschnitt aufgewickelt. Durch den länglichen Außenquerschnitt ist es möglich, den Platzbedarf des aufgewickelten Verbindungsabschnitts ein einer Querrichtung gering zu halten, was im Einzelfall die Unterbringung des aufgewickelten Verbindungsabschnitts in einem Kryostaten vereinfachen kann. Ebenso ist es möglich, insbesondere durch die Rotationsstellung des Wickelkörpers, d.h. die Ausrichtung der langen und kurzen Querachse, zum lokalen Magnetfeld eine Minimierung der Querkomponenten des Magnetfelds zum HTSL-Bandleiter einzurichten, und so die Stromtragfähigkeit zu optimieren.

Besonders vorteilhaft ist eine Weiterbildung, die vorsieht, dass die besagten ersten Enden des HTSL-Bandleiters und LTS-Drahts auf derselben Seite des Verbindungsabschnitts angeordnet sind, und dass der Verbindungsabschnitt mit den besagten ersten Enden des HTSL-Bandleiters und des LTS-Drahts innen liegend aufgewickelt ist. Dadurch wird eine umgekehrte Stromflussrichtung im HTSL-Bandleiter und im LTS-Draht im Bereich des Verbindungsabschnitts erreicht, wodurch ein Magnetfeld durch den Stromfluss im Verbindungsabschnitt minimiert wird. Zudem ist der Wickelprozess des Verbindungsabschnitts sehr einfach zu gestalten.

### Allgemeine Ausführungsformen der Magnetspulenanordnung

Bei einer vorteilhaften Ausführungsform ist vorgesehen, dass der Verbindungsabschnitt eine Länge von wenigstens 10 m aufweist. Durch eine größere Länge des Verbindungsabschnitts kann der ohmsche Widerstand zwischen dem HTSL-Bandleiter und dem LTS-Draht besonders stark verringert werden. In der Praxis können auch 20 m oder mehr als Länge für den Verbindungsabschnitt vorgesehen sein. Die Länge des Verbindungsabschnitts in Erstreckungsrichtung der Leiter (bzw. in oder entgegen der Stromflussrichtung) kann am einfachsten in einem abgewickelten Zustand bestimmt werden.

Der LTS-Draht ist zumindest im Bereich des Verbindungsabschnitts flach ausgebildet, insbesondere mit einer Breite, die der Breite des HTSL-Bandleiters entspricht. Der flache LTS-Draht ist dann mit einer Seite sehr gut an den HTSL-Bandleiter anzulegen; bei übereinstimmenden Breiten wird die für einen transversalen Stromaustausch zur Verfügung stehende Fläche optimiert. Typischerweise ist der LTS-Draht im Verbindungsabschnitt breitgewalzt. Ansonsten weist der LTS-Draht in der Regel einen runden oder rechteckigen Querschnitt auf.

Bevorzugt ist weiterhin eine Ausführungsform, bei der im Bereich des Verbindungsabschnitts Umhüllungen von LTS-Filamenten des LTS-Drahts ganz oder teilweise entfernt sind, insbesondere abgeätzt oder abgespült sind. Dadurch wird der ohmsche Widerstand beim Stromübergang zum HTSL-Bandleiter minimiert. Soweit der LTS-Draht eine Isolierung aufweist, ist diese im Bereich des Verbindungsabschnitts selbstredend ebenfalls ganz oder teilweise entfernt, um einen flächigen, elektrischen Kontakt herzustellen. Ebenso können Hüllteile des LTS-Drahts, etwa eine Kupferhülle, ganz oder teilweise entfernt sein.

Eine andere vorteilhafte Ausführungsform sieht vor, dass im Bereich des Verbindungsabschnitts eine oder mehrere Schutz-Schichten und/oder Shunt-Schichten auf einer HTSL-Schicht des HTSL-Bandleiters entfernt sind, insbesondere abgeätzt oder abgespült sind. Dadurch wird der ohmsche Widerstand beim Stromübergang zum LTS-Draht minimiert. Soweit der HTSL-Bandleiter eine Isolierung aufweist, ist diese im Bereich des Verbindungsabschnitts selbstredend ebenfalls ganz oder teilweise entfernt, um einen flächigen, elektrischen Kontakt herzustellen.

Besonders bevorzugt ist eine Ausführungsform, bei der der HTSL-Bandleiter und der LTS-Draht im Verbindungsabschnitt mit einem Lot miteinander verlötet sind. Mittels des Lots kann ein elektrisch gut leitfähiger, flächiger Kontakt zwischen dem HTSL-Bandleiter (bzw. dessen HTSL-Schicht) und dem LTS-Draht (bzw. dessen LTS-Filamenten) eingerichtet werden. Typischerweise ist das Lot durchgehend über die gesamte Länge des Verbindungsabschnitts und über die gesamte Breite des HTSL-Bandleiters aufgetragen.

Bei einer vorteilhaften Weiterbildung ist das Lot zinnhaltig. Zinnhaltiges Lot ist besonders gut zu verarbeiten und verflüssigt sich bei vergleichsweise niedrigen Temperaturen, so dass Beschädigungen des HTSL-Materials beim Verlöten vermieden oder zumindest minimiert werden können.

Vorteilhaft ist auch eine Ausführungsform, bei der der Verbindungsabschnitt von der Spulensektion, die mit dem HTSL-Bandleiter gewickelt ist, axial beabstandet ist. Dadurch kann die Magnetfeldstärke am Verbindungsabschnitt vermindert werden, was die Stromtragfähigkeit des Joints verbessert. Im Allgemeinen ist das Magnetfeld im Bereich des Verbindungsabschnitts auf ca. 1/10 oder weniger des maximalen Magnetfelds der Magnetspulenanordnung (im magnetischen Zentrum) abgefallen.

Bevorzugt ist eine Ausführungsform, bei der der LTS-Draht NbTi-haltige Filamente enthält. Mit NbTi als LTS-Material haben sich in der Praxis sehr zuverlässig Joints gemäß der Erfindung zu HTSL-Bandleitern, insbesondere vom ReBCO-Typ, fertigen lassen.

Ebenso bevorzugt ist eine Ausführungsform, bei der der HTSL-Bandleiter eine ReBCO enthaltende, insbesondere YBCO enthaltende HTSL-Schicht aufweist, mit Re: Element aus der Gruppe der seltenen Erden. Mit ReBCO als HTSL-Material haben sich in der Praxis sehr zuverlässig Joints gemäß der Erfindung zu LTS-Drähten, insbesondere mit NbTi-haltigen LTS-Drähten, fertigen lassen.

### Ausführungsformen mit weiteren oder zusätzlichen Joints

Bevorzugt ist auch eine Ausführungsform einer erfindungsgemäßen Magnetspulenanordnung, die vorsieht,
dass die Magnetspulenanordnung einen zusätzlichen LTS-Draht aufweist,
wobei der LTS-Draht und der zusätzliche LTS-Draht verschiedene supraleitende LTS-Materialien enthalten,
insbesondere wobei der zusätzliche LTS-Draht Nb3Sn enthält,
und dass der LTS-Draht an einem zweiten Endabschnitt vor einem vom HTSL-Bandleiter entfernten, zweiten Ende einen zusätzlichen Joint zu einem Endabschnitt des zusätzlichen LTS-Drahts ausbildet. Der zusätzliche Joint (meist zwischen NbTi und Nb3Sn) kann in im Stand der Technik bekannter Weise ausgebildet werden. Der zusätzliche LTS-Draht kann beispielsweise zu einer weiteren Spulensektion der Magnetspulenanordnung gehören. Der LTS-Draht (meist auf Basis von NbTi) kann hier als Vermittler zwischen dem HTSL-Bandleiter und dem zusätzlichen LTS-Draht (meist auf Basis von Nb3Sn) fungieren, wenn eine direkte Verjointung des HTSL-Bandleiters und des zusätzlichen LTS-Drahts technologisch schwierig ist (etwa aufgrund einer notwendigen Wärmebehandlung/Reaktionsglühung des zusätzlichen LTS-Drahts, der auf Nb3Sn basiert, was in der Nachbarschaft eines HTSL den HTSL beschädigen könnte).

Ebenso bevorzugt ist eine Ausführungsform, die vorsieht, dass die Magnetspulenanordnung einen weiteren LTS-Draht aufweist, wobei der HTSL-Bandleiter am ersten Endabschnitt vor seinem ersten Ende den Joint zum LTS-Draht und an einem zweiten Endabschnitt vor einem zweiten Ende des HTSL-Bandleiters einen weiteren Joint zum weiteren LTS-Draht ausbildet, insbesondere wobei der LTS-Draht und der weitere LTS-Draht das gleiche supraleitende LTS-Material enthalten. Mit dieser Ausführungsform kann der HTSL-Bandleiter leicht in einen Kurzschlussbetrieb der Magnetspulenanordnung integriert werden. Über den LTS-Draht und den weiteren LTS-Draht kann der HTSL-Bandleiter beidseitig niederohmig elektrisch verbunden werden. Der weitere Joint ist in dieser Ausführungsform wie der oben beschriebene Joint (zwischen HTSL-Bandleiter und LTS-Draht) erfindungsgemäß ausgebildet.

In den Rahmen der vorliegenden Erfindung fällt auch ein NMR-Spektrometer mit einer oben beschriebenen, erfindungsgemäßen Magnetspulenanordnung. (NMR=nuclear magnetic resonance, Kernspinresonanz).

Weitere Vorteile der Erfindung ergeben sich aus der Beschreibung und der Zeichnung. Ebenso können die vorstehend genannten und die noch weiter ausgeführten Merkmale erfindungsgemäß jeweils einzeln für sich oder zu mehreren in beliebigen Kombinationen Verwendung finden. Die gezeigten und beschriebenen Ausführungsformen sind nicht als abschließende Aufzählung zu verstehen, sondern haben vielmehr beispielhaften Charakter für die Schilderung der Erfindung.

### Detaillierte Beschreibung der Erfindung und Zeichnung

Die Erfindung ist in der Zeichnung dargestellt und wird anhand von Ausführungsbeispielen näher erläutert. Es zeigen:
- Fig. 1: einen schematischen, teilweise längsgeschnittenen Darstellung einer Ausführungsform einer erfindungsgemäßen Magnetspulenanordnung, mit einem zu einer Pancake-Spule aufgewickelten Verbindungsabschnitt zwischen einem HTSL-Bandleiter und einem LTS-Draht;
- Fig. 2: einen schematischen Querschnitt durch den Verbindungsabschnitt im Bereich der Schnittebene II von Fig. 1 und Fig. 3;
- Fig. 3: einen Ausschnitt aus Fig. 1 im Bereich des aufgewickelten Verbindungsabschnitts;
- Fig. 4: eine schematische Aufsicht auf eine weitere Ausführungsform einer erfindungsgemäßen Magnetspulenanordnung, mit einem zu einer Solenoidspule aufgewickelten Verbindungsabschnitt;
- Fig. 5: einen schematischen Längsschnitt durch eine Hälfte der Magnetspulenanordnung von Fig. 4;
- Fig. 6: eine schematische Darstellung eines erfindungsgemäßen NMR-Spektrometers umfassend eine erfindungsgemäße Magnetspulenanordnung;

- Fig. 7: einen schematischen Querschnitt durch einen zu einen zu einer Pancake-Spule aufgewickelten Verbindungsabschnitt, mit einem im Querschnitt länglichen Wickelkörper;
- Fig. 8: eine schematische Darstellung einer elektrischen Verschaltung einer weiteren Ausführungsform einer erfindungsgemäßen Magnetspulenanordnung;
- Fig. 9: eine schematische Darstellung eines Verbindungsabschnitts für die Erfindung, der nach Art einer Solenoidspule aufgewickelt ist, mit gekrümmter Solenoidspulenachse.

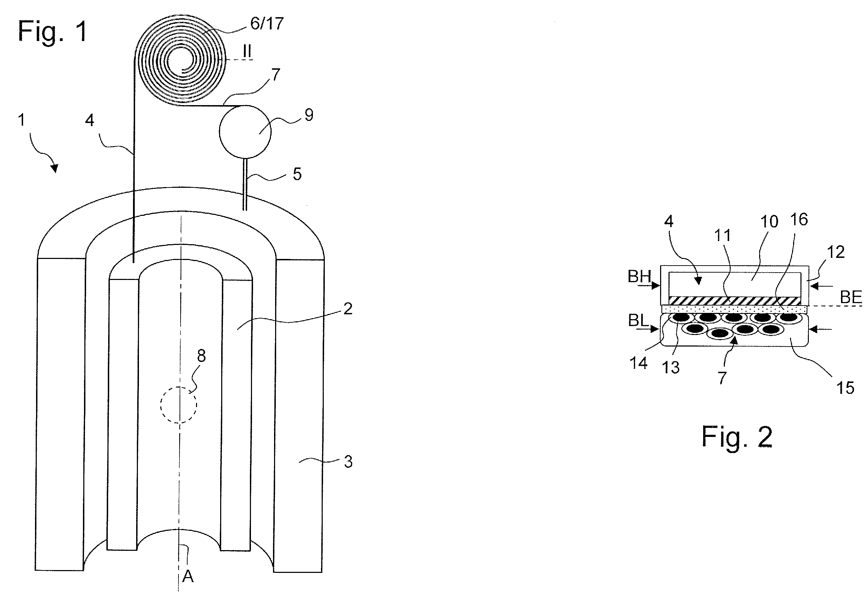

Die Fig. 1 illustriert eine Ausführungsform einer erfindungsgemäßen Magnetspulenanordnung 1, die beispielsweise in einem NMR-Spektrometer, insbesondere einem hochauflösenden NMR-Spektrometer, eingesetzt werden kann. Die Magnetspulenanordnung 1 umfasst hier zwei radial ineinander geschachtelte Spulensektionen 2, 3, die elektrisch seriell miteinander verbunden sind.

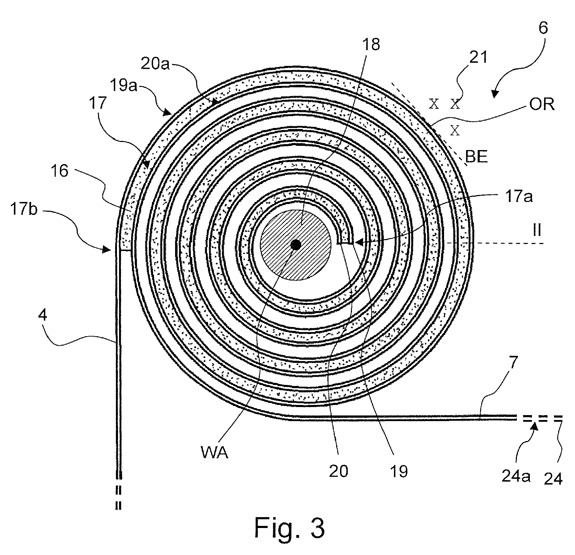

Die innen liegende, erste Spulensektion 2 ist mit mindestens einem HTSL-Bandleiter 4 gewickelt, hier nach Art eines Solenoids um die Spulenachse A. Der HTSL-Bandleiter 4 wird mit einem ersten Ende zu einem Joint 6 geführt, an welchem der HTSL-Bandleiter 4 mit einem LTS-Draht 7, hier enthaltend Filamente aus NbTi, niederohmig verbunden ist. Im Joint 6 sind der HTSL-Bandleiter 4 und der LTS-Draht 7 in einem Verbindungsabschnitt (Verbindungsbereich) 17 über eine Länge von hier 10 m parallel zueinander geführt und über diese Länge auch kontinuierlich elektrisch miteinander verbunden, insbesondere über eine Lötverbindung, wobei der Verbindungsabschnitt 17 aufgewickelt ist (siehe dazu auch Fig. 3). Der Joint 6 ist axial von der ersten Spulensektion 2 beabstandet angeordnet, so dass die von der Magnetspulenanordnung 1 erzeugte Magnetfeldstärke im Bereich des Joints 6 auf etwa 1/10 oder weniger der Magnetfeldstärke in einem Zentralbereich der Magnetspulenanordnung 1 in einem Probenvolumen 8 abgefallen ist.

Die zweite, außen liegende Spulensektion 3 der Magnetspulenanordnung 1 ist mit einem weiteren LTS-Draht 5, hier enthaltend Filamente aus Nb3Sn, gewickelt. Der LTS-Draht 7, enthaltend NbTi-Filamente, ist mit einem (aus dem Stand der Technik an sich bekannten) zusätzlichen Joint 9 mit dem weiteren LTS-Draht 5, enthaltend Nb3Sn-Filamente, verbunden. Im Bereich des zusätzlichen Joints 9 ist hier auch eine Spannvorrichtung für den weiteren LTS-Draht 5 integriert.

Die **Fig. 2** illustriert den Verbindungsabschnitt im Joint 6 der Fig. 1 in einem schematischen Querschnitt (mit der Schnittebene senkrecht zur Erstreckungsrichtung des HTSL-Bandleiters 4 und des LTS-Drahts 7, d.h. die Schnittebene der Fig. 2 liegt senkrecht zur Stromflussrichtung).

Der HTSL-Bandleiter 4 umfasst ein Substrat 10, auf dem eine HTSL-Schicht 11, hier aus YBCO-Material, abgeschieden ist. Der HTSL-Bandleiter 4 ist ausreichend flexibel, um ihn aufzuwickeln (vgl. dazu Fig. 1, Fig. 3); insbesondere kann das Substrat 10 als ein Stahlband ausgebildet sein. Eine typische Breite des HTSL-Bandleiters 4 beträgt 2mm bis 60mm. Zwischen dem Substrat 10 und der HTSL-Schicht 11 sind typischerweise eine oder mehrere Pufferschichten angeordnet, etwa aus CeO (nicht näher dargestellt). Der HTSL-Bandleiter 4 weist hier eine Shunt-Schicht 12 auf, hier aus Cu, die den HTSL-Bandleiter 4 allseitig umhüllt, jedoch im Verbindungsabschnitt auf der dem LTS-Draht 7 zugewandten Seite abgeätzt worden ist.

Der LTS-Draht 7 umfasst eine Vielzahl von NbTi-Filamenten 13, die hier jeweils von einer Umhüllung aus Nb 14 umgeben sind ("Nb-Barriere"). Die NbTi-Filamente13 sind in einer Matrix 15, etwa aus CuMn, angeordnet. Der LTS-Draht 7 wurde im Verbindungsabschnitt flach gewalzt, und ein Teil der Matrix 15 wurde abgeätzt, so dass ein Teil der NbTi-Filamente 13 an der dem HTSL-Bandleiter 4 zugewandten Seite freigelegt ist. Bei diesem oberflächennahen Teil der Filamente 13 ist auch die Umhüllung 14 an der dem HTSL-Bandleiter 4 zugewandten Seite abgeätzt.

Die HTSL-Schicht 11 und die NbTi-Filamente 13 des besagten oberflächennahen Teils stehen in direktem Kontakt mit einem elektrisch gut leitfähigen Lot 16, dass typischerweise zinnhaltig und/oder edelmetallhaltig, insbesondere Gold- und/oder Silber-haltig, ist. Dadurch ist eine elektrisch gut leitfähige Verbindung zwischen den Filamenten 13 und der HTSL-Schicht 11 eingerichtet. Man beachte, dass sich diese gut leitfähige Verbindung über die Länge des Verbindungsabschnitts (hier in Richtung senkrecht zur Zeichenebene) von hier 10 m erstreckt und dadurch der ohmsche Widerstand dieser Verbindung sehr gering wird. Eine typische Dicke des Lots 16 liegt zwischen 1 µm und 20 µm.

Man beachte, dass für einen optimalen Stromübertritt die Breite BL des LTS-Drahtes 7 (etwa durch geeignetes Ausführen des Walzens) der Breite BH des HTSL-Bandleiters 4 entsprechen sollte, und das Lot 16 im Wesentlichen die gesamte Breite BL bzw. BH überdecken sollte.

Die **Fig. 3** zeigt in einem vergrößerten Ausschnitt das Joint 6 aus Fig. 1. Zusätzlich markiert ist die Schnittebene II der Fig. 2.

Im Joint 6 sind der HTSL-Bandleiter 4 und der LTS-Draht 7 in der gezeigten Ausführungsform in einem spiralartig aufgewickelten Verbindungsabschnitt 17 flächig und kontinuierlich elektrisch miteinander verbunden, hier über das Lot 16, das zwischen dem HTSL-Bandleiter 4 und dem LTS-Draht 7 angeordnet ist. Der Verbindungsabschnitt 17 wird gebildet durch die Überlappung eines ersten Endabschnitts 19a des HTSL-Bandleiters 4, der sich von einem ersten Ende 19 des HTSL-Bandleiters 4 weg erstreckt, und eines ersten Endabschnitt 20a des LTS-Drahts 7, der sich von einem ersten Ende 20 des LTS-Drahts 7 weg erstreckt.

Der Verbindungsabschnitt 17 ist auf einem hier im Querschnitt kreisrunden Wickelkörper 18 um eine Wickelachse WA, die senkrecht zur Zeichenebene verläuft, aufgewickelt, hier nach Art einer Pancake-Spule mit nur einer Windung je Lage. Durch das Aufwickeln des Verbindungsabschnitts 17 kann diesertrotz seiner Länge in Erstreckungsrichtung des HTSL-Bandleiters 4 bzw. des LTS-Drahts 7 von hier 10 m - kompakt untergebracht werden, typischerweise mit einem Durchmesser der Wickelschnecke von 20 cm oder weniger.

Die ersten Enden 19, 20 des HTSL-Drahts 4 und des LTS-Drahts 7, von denen sich die ersten Endabschnitte 19a, 20a weg erstrecken, liegen dabei an derselben, in der Aufwicklung radial innen angeordneten Seite (Endseite) 17a des Verbindungsabschnitts 17. An der anderen Seite (Endseite) 17b des Verbindungsabschnitts 17, die bezüglich der Aufwicklung radial außen liegt, teilen sich der HTSL-Bandleiter 4 und der LTS-Draht 7 auf.

Der Wickelkörper 18 bzw. die Wickelachse WA sind so positioniert und orientiert, dass das von der Magnetspulenanordnung erzeugte lokale Magnetfeld 21 im Wesentlichen parallel zur jeweiligen lokalen Bandebene BE des HTSL-Bandleiters 4 (bzw. zur lokalen Oberfläche der HTSL-Schicht des HTSL-Bandleiters 4) verläuft. Beispielhaft wird das in Fig. 3 an einer außen liegenden Windung erläutert. Die lokale Bandebene BE des HTSL-Bandleiters 4 am Ort OR erstreckt sich dort anliegend ("tangential") an dem HTSL-Bandleiter 4 und senkrecht zur Zeichenebene. Die lokalen Feldlinien des Magnetfelds 21 nahe des Orts OR verlaufen weiterhin senkrecht zur Zeichenebene. Entsprechend sind die Bandebene BE und die Feldlinien zueinander parallel ausgerichtet. Dadurch kann die Stromtragfähigkeit im HTSL-Bandleiter 4 optimiert werden. In der Fig. 2 ist ebenfalls eine Bandebene BE eingezeichnet. Man beachte, dass die Bandebene BE bei einem aufgewickelten HTSL-Bandleiter entlang des Bandleiters veränderlich ist ("lokale Bandebene").

Am einfachsten wird eine geeignete Orientierung des HTSL-Bandleiters 4 zum Magnetfeld 21 erreicht, wenn die lokale Bandebene BE im Verbindungsabschnitt 17 überall zumindest im Wesentlichen parallel zur Wickelachse WA verlauft, und die Wickelachse WA ihrerseits zumindest im Wesentlichen parallel zum Magnetfeld 21 im Gebiet des Verbindungsabschnitts 17 verläuft. In der Regel wird die Wickelachse WA parallel zum Magnetfeld im Zentrum des Verbindungsabschnitts 17 (Mitte des Wickelkörpers 18) ausgerichtet. Es sollte erwähnt werden, dass das Magnetfeld 21 über das gesamte Gebiet des Verbindungsabschnitts 17/Joints 6 grundsätzlich lokal veränderlich ist, da Magnetfelder stets mit geschlossenen Linien verlaufen und daher Krümmungen aufweisen. Daher können in einer realen Magnetspulenanordnung, mit einer merklichen räumlichen Ausdehnung des Verbindungsabschnitts, Ausrichtungen zum lokalen Magnetfeld nur mit einem gewissen Spielraum angegeben werden. Soweit hier angegeben wird, dass eine Ausrichtung zweier Größen im Wesentlichen parallel erfolgen soll, so ist diese Bedingung erfüllt, wenn die (größte) Abweichung von der Parallelität weniger als 20°, bevorzugt weniger als 10°, besonders bevorzugt weniger als 5° beträgt.

In der dargestellten Ausführungsform wird ein zweiter Endabschnitt 24a vor einem zweiten Ende 24 des LTS-Drahts 7 im zusätzlichen Joint 9 mit einem Endbereich des zusätzlichen LTS-Draht 5 (vgl. Fig. 1) verbunden (in Fig. 3 nicht näher dargestellt).

Man beachte, dass für einen Betrieb der Magnetspulenanordnung 1 in einem supraleitenden Kurzschlussbetrieb typischerweise ein zweiter Joint, insbesondere entsprechend dem Joint 6, oder auch eine zweite Jointanordnung, insbesondere entsprechend dem Joint 6 und dem zusätzlichen Joint 9, eingesetzt werden kann.

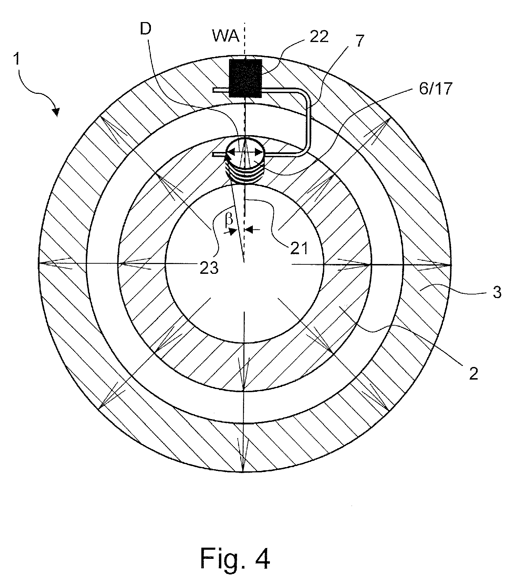

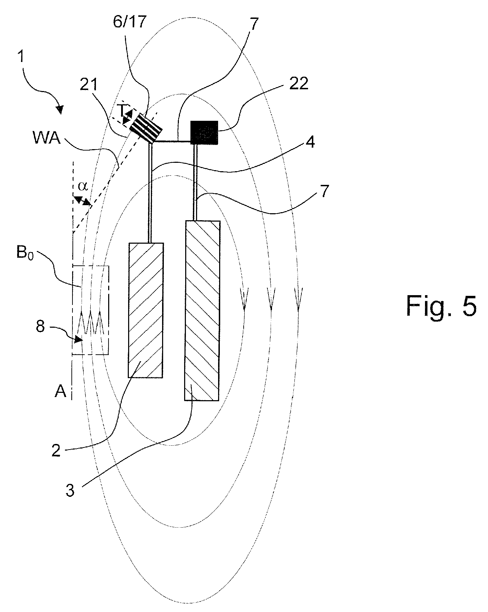

Fig. 4 und Fig. 5 zeigen eine weitere Ausführungsform einer erfindungsgemäßen Magnetspulenanordnung 1 in einer Aufsicht, vgl. **Fig. 4****,** und in einem Längsschnitt über eine Hälfte der Magnetspulenanordnung 1, vgl. **Fig. 5****.**

Die Magnetspulenanordnung 1 erzeugt in einem hier zylindrischen Probenvolumen 8, das typischerweise wenigstens 1 cm³, und bevorzugt 10 cm³ umfasst, ein statisches Magnetfeld B₀ mit einer Homogenität von typischerweise 100 ppm oder besser, bevorzugt 10 ppm oder besser, besonders bevorzugt 2 ppm oder besser, vor einem Shimvorgang, d.h. ohne weitere Homogenisierung durch mit unabhängigen Shimströmen betriebenen Shimspulen und/oder ferromagnetische Shimplättchen. Die Magnetspulenanordnung 1 umfasst eine erste Spulensektion 2, die mit einem HTSL-Bandleiter 4 gewickelt ist, und eine zweite Spulensektion 3, die mit einem LTS-Draht 7 gewickelt ist. Der LTS-Draht 7 ist hier mit NbTi-Filamenten ausgestattet. Der LTS-Draht 7 wird in der gezeigten Ausführungsform mit einer Spannvorrichtung 22 gespannt, um eine optimale Lage des LTS-Drahts 7 in der zweiten Spulensektion 3 zu erreichen.

Der HTSL-Bandleiter 4 und der LTS-Draht 7 sind in einem Joint 6 gemäß der Erfindung elektrisch leitend miteinander verbunden. Der Joint 6 umfasst hier einen solenoidförmig aufgewickelten Verbindungsabschnitt 17, vgl. die einzelnen benachbarten Windungen in der obersten Lage. Um eine Wickelachse WA sind dabei mit mehreren Windungen je Lage der HTSL-Bandleiter 4 und der LTS-Draht 7 parallel und flächig miteinander verbunden aufgewickelt; die lokale Bandebene des HTSL-Bandleiters 4 ist überall zumindest im Wesentlichen parallel zur Wickelachse WA ausgerichtet.

Die Wickelachse WA ist in der gezeigten Ausführungsform um einen Winkel α von hier ca. 35° gegen die Achse A der Magnetspulenanordnung 1 gekippt, um die Wickelachse WA im Wesentlichen parallel zum lokalen Magnetfeld 21 im Verbindungsabschnitt 17 bzw. im Volumen des Joints 6 auszurichten.

Aufgrund der hier geringen Tiefe T des Joints 6 (Spulenlänge der "Jointspule") kommt es im Längsschnitt (Fig. 5) dabei über die Tiefe T zu keinen merklichen Abweichungen von der Parallelität zwischen der Wickelachse WA und dem lokalem Magnetfeld 21. Andererseits ist aber in der Aufsicht (Fig. 4) zu erkennten, dass der Joint 6 einen erheblichen Durchmesser D aufweist, so dass eine Feldlinie 23 des lokalen Magnetfelds 21 im Randbereich des Joints 6 bereits einen Winkel β von hier ca. 7° gegen die Wickelachse WA einschließt. Eine solch geringe Abweichung von der Parallelität sorgt aber nur für eine geringe, noch gut akzeptable Verringerung der Stromtragfähigkeit des Joints 6.

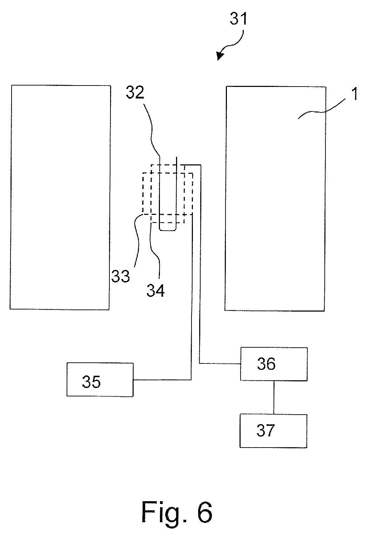

In der **Fig. 6** ist ein erfindungsgemäßes NMR-Spektrometer 31 beispielhaft schematisch dargestellt, in welchem eine erfindungsgemäße Magnetspulenanordnung 1 eingesetzt werden kann.

Das NMR-Spektrometer 31 umfasst eine erfindungsgemäße Magnetspulenanordnung (NMR-Magnetspule) 1, beispielsweise wie in Fig. 1 dargestellt, die typischerweise in einem Kryostaten angeordnet ist (nicht näher dargestellt). Im magnetischen Zentrum der Magnetspulenanordnung 1 ist in einem Probenvolumen eine Probe 32 (etwa ein mit einer zu untersuchenden Substanz gefülltes Probenröhrchen) angeordnet. Die Probe 32 ist von einer HF-Sendespule 33 und einer HF-Empfangsspule 34 umgeben (Man beachte, dass in anderen Bauformen auch kombinierte HF-Sende- und Empfangsspulen möglich sind). Mit einem HF-Generator 35 und der Sendespule 33 werden HF-Impulse in die Probe 32 eingestrahlt. Mit einem HF-Detektor 36 und der HF-Empfangsspule 34 wird die Antwort der Probe 32 vermessen. Die Messergebnisse werden mit einer Auswerteeinheit 37 verarbeitet, und beispielsweise in ein NMR-Spektrum umgewandelt.

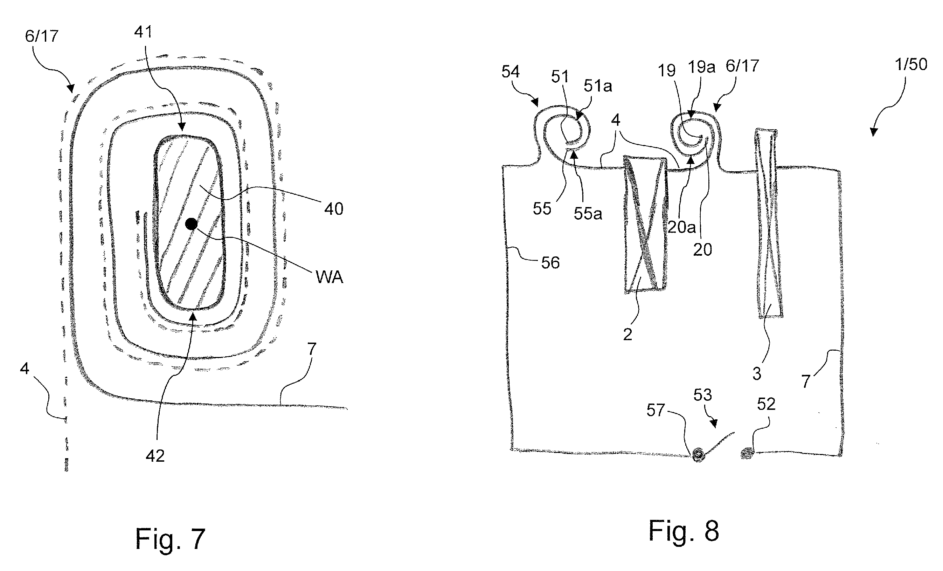

**Fig. 7** illustriert im schematischen Querschnitt einen weiteren Joint 6 bzw. einen Verbindungsabschnitt 17 eines HTSL-Bandleiters 4 (gestrichelt dargestellt) und eines LTS-Drahts 7 (durchgezogen dargestellt), ähnlich wie in Fig. 3 dargestellt und beschrieben. Zur Vereinfachung werden im Folgenden nur die Unterschiede näher erläutert, und ein den HTSL-Draht 4 und den LTS-Draht 7 verbindendes Lot ist nicht näher dargestellt.

Der Verbindungsabschnitt 17 ist hier um eine Wickelachse WA auf einem im Querschnitt länglichen Wickelkörper 40 aufgewickelt, wobei die in der langen Richtung gegenüberliegenden Enden 41, 42 abgerundet ausgebildet sind, so dass ein anliegender HTSL-Bandleiter 4 oder LTS-Draht 7 keinen scharfen Knick am Übergang zwischen einer langen Seite und eine kurzen Seite erfährt. Der Joint 6 ist in (in Fig. 7) der Richtung von links nach rechts besonders kompakt ausgebildet, was eine Unterbringung in einem Kryostaten vereinfachen kann.

In der **Fig. 8** ist schematisch ein elektrischer Schaltkreis 50 für eine weitere Ausführungsform einer erfindungsgemäßen Magnetspulenanordnung 1 dargestellt. Eine erste Spulensektion 2 ist hierbei mit einem HTSL-Bandleiter 4 gewickelt. Ein erster Endabschnitt 19a vor einem ersten Ende 19 des HTSL-Bandleiters 4 ist mit einem ersten Endabschnitt 20a vor einem ersten Ende 20 eines LTS-Drahts 7 (hier mit NbTi-Filamenten) in einem Joint 6 bzw. entlang eines Verbindungsabschnitts 17 leitend verbunden; der Verbindungsabschnitt 17 ist aufgewickelt.

Der LTS-Draht 7 bildet eine zweite Spulensektion 3 aus. Der LTS-Draht 7 endet mit seinem zweiten Ende 52 an einem supraleitenden Schalter 53; im Bereich des supraleitenden Schalters 53 kann auch eine Stromeinspeisung zum Aufladen der Magnetspulenanordnung 1 vorgesehen sein.

Ein zweiter Endabschnitt 51a vor einem zweiten Ende 51 des HTSL-Bandleiters 4 ist in einem weiteren Joint 54 bzw. einem weiteren Verbindungsabschnitt mit einem ersten Endabschnitt 55a vor einem ersten Ende 55 eines weiteren LTS-Drahts 56 (hier ebenfalls mit NbTi-Filamenten) verbunden. Der weitere Joint 54 bzw. der weitere Verbindungsabschnitt sind entsprechend dem Joint 6 bzw. dem Verbindungsabschnitt 17 aufgebaut; insbesondere ist der weitere Verbindungsabschnitt ebenfalls aufgewickelt. Der weitere LTS-Draht 56 führt mit seinem zweiten Ende 57 zur anderen Seite des supraleitenden Schalters 53.

Im Kurzschlussbetrieb, mit supraleitend geschlossenem supraleitenden Schalter 53, kann die Magnetspulenanordnung 1 mit einem abgesehen von einer sehr kleinen Drift konstanten Kreisstrom betrieben werden, wobei die Spulensektionen 2, 3 in einem Probenvolumen ein zeitlich konstantes, statisches Magnetfeld B₀ erzeugen. Die Drift an den Joints 6, 54 kann gegebenenfalls vernachlässigt werden, oder auch mit an sich bekannten Mitteln zur Driftkompensation kompensiert werden.

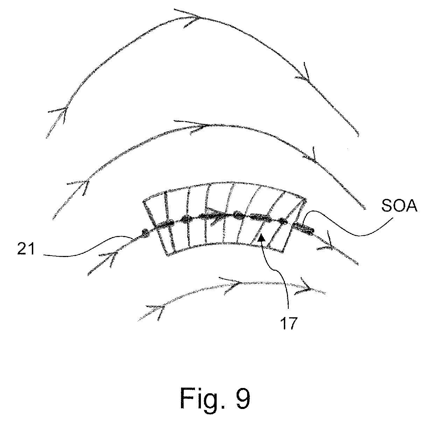

**Fig. 9** zeigt einen Verbindungsabschnitt 17, der nach Art einer Solenoidspule aufgewickelt ist. Dabei ist jedoch die zugehörige Solenoidspulenachse SOA, die in Fig. 9 strichpunktiert dargestellt ist und um die der HTSL-Bandleiter und der LTS-Draht gewickelt sind, gekrümmt. Die Krümmung entspricht dabei dem Verlauf des lokalen Magnetfelds 21 im radialen Zentrum des Verbindungsabschnitts 17. Dadurch können Querkomponenten des Magnetfelds (die senkrecht zur lokalen Bandebene im HTSL-Bandleiter verlaufen) minimiert werden, so dass die Stromtragfähigkeit im Verbindungsabschnitt 17 maximiert ist.

## Patentansprüche

1. Magnetspulenanordnung (1), umfassend
- mindestens eine Spulensektion (2), die mit einem Hochtemperatursupraleiter(=HTSL)-Bandleiter (4) gewickelt ist,
- und einen Tieftemperatursupraleiter(=LTS)-Draht (7),
wobei der HTSL-Bandleiter (4) und der LTS-Draht (7) elektrisch in Serie geschaltet sind,
und wobei der HTSL-Bandleiter (4) und der LTS-Draht (7) einen Joint (6) ausbilden,
**dadurch gekennzeichnet,**
**dass** ein erster Endabschnitt (19a) des HTSL-Bandleiters (4) vor einem ersten Ende (19) des HTSL-Bandleiters (4) und ein erster Endabschnitt (20a) des LTS-Drahts (7) vor einem ersten Ende (20) des LTS-Drahts (7) in einem Verbindungsabschnitt (17) über die Länge des Verbindungsabschnitts (17) elektrisch, jedoch nicht supraleitend, miteinander verbunden sind,
wobei der LTS-Draht (7) zumindest im Bereich des Verbindungsabschnitts (17) flach ausgebildet ist und der flache LTS-Draht (7) mit einer Seite an den HTSL-Bandleiter (4) angelegt ist,
und **dass** der Verbindungsabschnitt (17) eine Länge von wenigstens 5 m aufweist.

2. Magnetspulenanordnung (1) nach Anspruch 1, **dadurch gekennzeichnet, dass** der Verbindungsabschnitt (17) aufgewickelt ist.

3. Magnetspulenanordnung (1) nach Anspruch 2, **dadurch gekennzeichnet, dass** der HTSL-Bandleiter (4) im Bereich des Verbindungsabschnitts (17) mit einer jeweiligen lokalen Bandebene (BE) im Wesentlichen parallel zu einer Wickelachse (WA) verläuft,
und dass der Verbindungsabschnitt (17) so positioniert ist, dass das von der Magnetspulenanordnung (1) im Betrieb erzeugte Magnetfeld (21) im Bereich des Verbindungsabschnitts (17) im Wesentlichen parallel zur Wickelachse (WA) verläuft.

4. Magnetspulenanordnung (1) nach Anspruch 3, **dadurch gekennzeichnet, dass** die Wickelachse (WA) gegenüber einer Spulenachse (A) der Magnetspulenanordnung (1) gekippt ist, insbesondere mit einem Kippwinkel (α) zwischen 20° und 70°, bevorzugt zwischen 30° und 60°.

5. Magnetspulenanordnung (1) nach Anspruch 2, 3 oder 4, **dadurch gekennzeichnet, dass** der Verbindungsabschnitt (17) nach Art einer Pancake-Spule aufgewickelt ist.

6. Magnetspulenanordnung (1) nach Anspruch 2, 3 oder 4, **dadurch gekennzeichnet, dass** der Verbindungsabschnitt (17) nach Art einer Solenoidspule aufgewickelt ist.

7. Magnetspulenanordnung (1) nach Anspruch 6, **dadurch gekennzeichnet, dass** eine Solenoidspulenachse (SOA), um die der Verbindungsabschnitt (17) gewickelt ist, gekrümmt verläuft, insbesondere wobei der Verlauf der Solenoidspulenachse (SOA) dem Feldlinienverlauf eines von der Magnetspulenanordnung (1) im Betrieb erzeugten, lokalen Magnetfelds (21) entspricht.

8. Magnetspulenanordnung (1) nach einem der Ansprüche 2 bis 7, **dadurch gekennzeichnet, dass** die besagten ersten Enden (19, 20) des HTSL-Bandleiters (4) und LTS-Drahts (7) auf derselben Seite (17a) des Verbindungsabschnitts (17) angeordnet sind, und dass der Verbindungsabschnitt (17) mit den besagten ersten Enden (19, 20) des HTSL-Bandleiters (4) und des LTS-Drahts (7) radial innen liegend aufgewickelt ist.

9. Magnetspulenanordnung (1) nach einem der vorhergehenden Ansprüche, **dadurch gekennzeichnet, dass** im Bereich des Verbindungsabschnitts (17) Umhüllungen (14) von LTS-Filamenten (13) des LTS-Drahts (7) ganz oder teilweise entfernt sind, insbesondere abgeätzt oder abgespült sind.

10. Magnetspulenanordnung (1) nach einem der vorhergehenden Ansprüche, **dadurch gekennzeichnet, dass** im Bereich des Verbindungsabschnitts (17) eine oder mehrere Schutz-Schichten und/oder Shunt-Schichten (12) auf einer HTSL-Schicht (11) des HTSL-Bandleiters (4) entfernt sind, insbesondere abgeätzt oder abgespült sind.

11. Magnetspulenanordnung (1) nach einem der vorhergehenden Ansprüche, **dadurch gekennzeichnet, dass** der HTSL-Bandleiter (4) und der LTS-Draht (7) im Verbindungsabschnitt (17) mit einem Lot (16) miteinander verlötet sind.

12. Magnetspulenanordnung (1) nach einem der vorhergehenden Ansprüche, **dadurch gekennzeichnet, dass** der Verbindungsabschnitt (17) von der Spulensektion (2), die mit dem HTSL-Bandleiter (4) gewickelt ist, axial beabstandet ist.

13. Magnetspulenanordnung (1) nach einem der vorhergehenden Ansprüche, **dadurch gekennzeichnet,**
**dass** die Magnetspulenanordnung (1) einen zusätzlichen LTS-Draht (5) aufweist, wobei der LTS-Draht (7) und der zusätzliche LTS-Draht (5) verschiedene supraleitende LTS-Materialien enthalten,
insbesondere wobei der zusätzliche LTS-Draht Nb3Sn enthält,
und **dass** der LTS-Draht (7) an einem zweiten Endabschnitt (24a) vor einem vom HTSL-Bandleiter (4) entfernten, zweiten Ende (24) einen zusätzlichen Joint (9) zu einem Endabschnitt des zusätzlichen LTS-Drahts (5) ausbildet.

14. Magnetspulenanordnung (1) nach einem der vorhergehenden Ansprüche, **dadurch gekennzeichnet, dass** die Magnetspulenanordnung (1) einen weiteren LTS-Draht (56) aufweist, wobei der HTSL-Bandleiter (4) am ersten Endabschnitt (19a) vor seinem ersten Ende (19) den Joint (6) zum LTS-Draht (7) und an einem zweiten Endabschnitt (51 a) vor einem zweiten Ende (51) des HTSL-Bandleiters (4) einen weiteren Joint (54) zum weiteren LTS-Draht (56) ausbildet,
insbesondere wobei der LTS-Draht (7) und der weitere LTS-Draht (56) das gleiche supraleitende LTS-Material enthalten.

15. NMR-Spektrometer (31) mit einer Magnetspulenanordnung (1) nach einem der vorhergehenden Ansprüche.

## Claims

1. A magnet coil system (1), comprising
- at least one coil section (2), wound with a high temperature superconductor (=HTSL) tape conductor (4),
- and a low temperature superconductor (=LTS) wire (7),
the HTSL-tape conductor (4) and the LTS wire (7) being electrically connected in series,
- and the HTSL-tape conductor (4) and the LTS wire (7) forming a joint (6),
**characterized in that**
a first end section (19a) of the HTSL-tape conductor (4) located before a first end (19) of the HTSL-tape conductor (4) and a first end section (20a) of the LTS wire (7) located before a first end (20) of the LTS wire (7) are connected electrically, but not in a superconducting way, in a connecting section (17) along the length of the connecting section (17),
the LTS wire (7) having a flat shape at least in the area of the connecting section (17) and one side of the flat LTS wire (7) abutting on the HTSL-tape conductor (4), and the connecting section (17) exhibiting a length of at least 5 m.

2. The magnet coil system (1) according to claim 1, **characterized in that** the connecting section (17) is wound up.

3. The magnet coil system (1) according to claim 2, **characterized in that** in the area of the connecting section (17), a respective local tape plane (BE) of the HTSL-tape conductor (4) essentially extends parallel to a winding axis (WA),
and that the connecting section (17) is positioned such that the magnetic field (21) generated by the magnet coil system (1) during operation is essentially directed parallel to the winding axis (WA) in the area of the connecting section (17).

4. The magnet coil system (1) according to claim 3, **characterized in that** the winding axis (WA) is tilted with respect to a coil axis (A) of the magnet coil system (1), in particular with a tilt angle (α) between 20° and 70°, preferably between 30° and 60°.

5. The magnet coil system (1) according to claim 2, 3 or 4, **characterized in that** the connecting section (17) is wound in the manner of a pancake-coil.

6. The magnet coil system (1) according to claim 2, 3 or 4, **characterized in that** the connecting section (17) is wound in the manner of a solenoid coil.

7. The magnet coil system (1) according to claim 6, **characterized in that** a solenoid coil axis (SOA), about which the connecting section (17) is wound, extends in a curved manner, in particular wherein the progression of the solenoid coil axis (SOA) follows the field line progression of a local magnetic field (21) generated by the magnet coil system (1) during operation.

8. The magnet coil system (1) according to any one of the claims 2 to 7, **characterized in that** said first ends (19, 20) of the HTSL-tape conductor (4) and of the LTS wire (7) are located on the same side (17a) of the connecting section (17), and that the connecting section (17) is wound such that said first ends (19, 20) of the HTSL-tape conductor (4) and of the LTS wire (7) have a radially inner position.

9. The magnet coil system (1) according to any one of the preceding claims, **characterized in that** in the area of the connecting section (17) encasings (14) of LTS filaments (13) of the LTS wire (7) have been completely or partially removed, in particular etched away or rinsed away.

10. The magnet coil system (1) according to any one of the preceding claims, **characterized in that** in the area of the connecting section (17) one or more protective layers and/or shunt layers (12) on an HTSL layer (11) of the HTSL-tape conductor (4) have been removed, in particular etched away or rinsed away.

11. The magnet coil system (1) according to any one of the preceding claims, **characterized in that** the HTSL-tape conductor (4) and the LTS wire (7) are soldered to each other by means of solder (16) in the connecting section (17).

12. The magnet coil system (1) according to any one of the preceding claims, **characterized in that** the connecting section (17) is axially spaced apart from the coil section (2) which is wound with the HTSL-tape conductor (4).

13. The magnet coil system (1) according to any one of the preceding claims, **characterized in that** the magnet coil system (1) comprises an additional LTS wire (5), the LTS wire (7) and the additional LTS wire (5) containing different superconducting LTS materials, in particular the additional LTS wire containing Nb3Sn, and the LTS wire (7) exhibiting at a second end section (24a) before a second end (24) remote from the HTSL-tape conductor (4), an additional joint (9) to an end section of the additional LTS wire (5).

14. The magnet coil system (1) according to any one of the preceding claims, **characterized in that** the magnet coil system (1) comprises a further LTS wire (56), wherein the HTSL-tape conductor (4) forms at the first end section (19a) before its first end (19) the joint (6) to the LTS wire (7), and forms at a second end section (51 a) before a second end (51) of the HTSL-tape conductor (4) a further joint (54) to the further LTS wire (56), in particular wherein the LTS wire (7) and the further LTS wire (56) contain the same superconducting LTS material.

15. NMR spectrometer (31) comprising a magnet coil system (1) according to any one of the preceding claims.

## Revendications

1. Dispositif à bobine électromagnétique (1), comprenant
- au moins une section de bobine (2) qui est enroulée avec un ruban supraconducteur haute température (= HTSL) (4),
- et un fil supraconducteur basse température (= LTS) (7),
le ruban HTSL (4) et le fil LTS (7) étant couplés électriquement en série,
et le ruban HTSL (4) et le fil LTS (7) formant un joint (6),
**caractérisé en ce**
**qu'**une première section terminale (19a) du ruban HTSL (4) avant une première extrémité (19) du ruban HTSL (4) et une première section terminale (20a) du fil LTS (7) avant une première extrémité (20) du fil LTS (7) sont reliées entre elles électriquement, mais de manière non supraconductrice, en une section de liaison (17), sur la longueur de la section de liaison (17),
le fil métallique LTS (7) étant de forme plate, au moins dans la zone de la section de liaison (17), et le fil métallique LTS plat (7) étant appliqué, par un côté, sur le ruban HTSL (4),
et **que** la section de liaison (17) présente une longueur d'au moins 5 m.

2. Dispositif à bobine électromagnétique (1) selon la revendication 1, **caractérisé en ce que** la section de liaison (17) est enroulée.

3. Dispositif à bobine électromagnétique (1) selon la revendication 2, **caractérisé en ce que** le ruban HTSL (4) s'étend sensiblement parallèlement à un axe d'enroulement (WA) dans la zone de la section de liaison (17) par un plan de ruban local respectif (BE),
et que la section de liaison (17) est positionnée de façon que le champ magnétique (21) généré en fonctionnement par le dispositif à bobine électromagnétique (1) s'étende sensiblement parallèlement à l'axe d'enroulement (WA) dans la zone de la section de liaison (17).

4. Dispositif à bobine électromagnétique (1) selon la revendication 3, **caractérisé en ce que** l'axe d'enroulement (WA) est incliné par rapport à un axe de bobine (A) du dispositif à bobine électromagnétique (1), en particulier d'un angle d'inclinaison (α) compris entre 20° et 70°, de préférence entre 30° et 60°.

5. Dispositif à bobine électromagnétique (1) selon l'une des revendications 2, 3 ou 4, **caractérisé en ce que** la section de liaison (17) est enroulée à la manière d'une bobine en galette.

6. Dispositif à bobine électromagnétique (1) selon l'une des revendications 2, 3 ou 4, **caractérisé en ce que** la section de liaison (17) est enroulée à la manière d'un solénoïde.

7. Dispositif à bobine électromagnétique (1) selon la revendication 6, **caractérisé en ce qu'**un axe de solénoïde (SOA), autour duquel la section de liaison (17) est enroulée, s'étend de manière courbe, l'extension de l'axe de solénoïde (SOA) correspondant en particulier à l'extension des lignes de champ d'un champ magnétique local (21) généré par le dispositif à bobine électromagnétique (1) en fonctionnement.

8. Dispositif à bobine électromagnétique (1) selon l'une des revendications 2 à 7, **caractérisé en ce que** lesdites premières extrémités (19, 20) du ruban HTSL (4) et du fil LTS (7) sont disposées du même côté (17a) de la section de liaison (17), et que la section de liaison (17) avec lesdites premières extrémités (19, 20) du ruban HTSL (4) et du fil LTS (7) est enroulée radialement intérieurement.

9. Dispositif à bobine électromagnétique (1) selon l'une des revendications précédentes, **caractérisé en ce que** dans la zone de la section de liaison (17), des enveloppes (14) de filaments LTS (13) du fil LTS (7) sont enlevées en totalité ou en partie, en particulier corrodées ou rincées.

10. Dispositif à bobine électromagnétique (1) selon l'une des revendications précédentes, **caractérisé en ce que** dans la zone de la section de liaison (17), une ou plusieurs couches de protection et/ou couches de shunt (12) sur une couche HTSL (11) du ruban HTSL (4) sont enlevées, en particulier corrodées ou rincées.

11. Dispositif à bobine électromagnétique (1) selon l'une des revendications précédentes, **caractérisé en ce que** le ruban HTSL (4) et le fil LTS (7) sont brasés ensemble par un métal d'apport de brasage (16) dans la section de liaison (17).

12. Dispositif à bobine électromagnétique (1) selon l'une des revendications précédentes, **caractérisé en ce que** la section de liaison (17) est espacée axialement de la section de bobine (2) qui en enroulée avec le ruban HTSL (4).

13. Dispositif à bobine électromagnétique (1) selon l'une des revendications précédentes, **caractérisé en ce**
**que** le dispositif à bobine électromagnétique (1) présente un fil LTS supplémentaire (5), le fil LTS (7) et le fil LTS supplémentaire (5) contenant des matériaux supraconducteurs LTS différents, en particulier le fil LTS supplémentaire contenant Nb3Sn,
et **que** le fil LTS (7) forme à une deuxième section terminale (24a), avant une deuxième extrémité (24) éloignée du ruban HTSL (4), un joint supplémentaire (9) avec une section terminale du fil LTS supplémentaire (5).

14. Dispositif à bobine électromagnétique (1) selon l'une des revendications précédentes, **caractérisé en ce que** le dispositif à bobine électromagnétique (1) présente un autre fil LTS (56), le ruban HTSL (4) formant à la première section terminale (19a), avant sa première extrémité (19), le joint (6) avec le fil LTS (7) et à une deuxième section terminale (51a), avant une deuxième extrémité (51) du ruban HTSL (4), un autre joint (54) avec l'autre fil LTS (56),
en particulier le fil LTS (7) et l'autre fil LTS (56) contenant le même matériau supraconducteur LTS.

15. Spectromètre RMN (31) doté d'un dispositif à bobine électromagnétique (1) selon l'une des revendications précédentes.
